# EUROPÄISCHE PATENTSCHRIFT

(11) **EP 0 467 135 B1**
(45) Veröffentlichungstag und Bekanntmachung des Hinweises auf die Patenterteilung: **17.12.1997**
(21) Anmeldenummer: 91110804.1
(22) Anmeldetag: 29.06.1991
(51) Int. Cl.: G03F 7/11

(54) **Photopolymersierbare Druckplatte für den Flexodruck**
Photopolymerizable printing plate for flexographic printing
Cliché photopolymérisable pour l'impression flexographique

(30) Priorität: 19.07.1990 DE 4022980
(43) Veröffentlichungstag der Anmeldung: 22.01.1992
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Abele, Werner, Dr., W-6078 Neu-Isenburg (DE)

(56) Entgegenhaltungen:
- EP-A- 0 084 851
- EP-A- 0 206 412
- EP-A- 0 322 585

## Beschreibung

Die Erfindung betrifft photopolymerisierbare Druckplatten, deren wesentliche Bestandteile eine photopolymerisierbare Schicht und eine auf dieser Schicht aufgebrachte elastomere Schicht, enthaltend mindestens ein thermoplastisch elastomeres Blockcopolymer und mindestens ein Polymer mit einer Struktureinheit A gemäß Anspruch 1, sind. Aus diesen Materialien hergestellte Druckformen für den Flexodruck weisen ein verbessertes Druckverhalten besonders mit alkoholischen und wäßrigen Druckfarben auf.

Es ist bekannt, für die Herstellung von Druckformen für den Flexodruck photopolymerisierbare Aufzeichnungsmaterialien zu verwenden, bei denen die Druckoberfläche durch bildmäßiges Belichten einer lichtempfindlichen Schicht und anschließendes Entfernen der unbelichteten Schichtteile erzeugt wird. Hierbei kann man zwischen festen, photopolymerisierbaren Materialien und solchen, bei denen die bildmäßige Belichtung an flüssigen Systemen durchgeführt wird, unterscheiden. Außerdem gibt es sowohl wäßrig entwickelbare als auch mit organischen Lösungsmitteln entwickelbare, photopolymerisierbare Aufzeichnungsmaterialien.

Ein Beispiel für ein flüssiges System, das wäßrig entwickelbar ist, findet sich in EP-A2 02 61 890, wo flüssige, in wäßrigem Medium lösliche Kohlenwasserstoff-Maleat-Polymere mit über Estergruppen gebundenen (Meth)acrylsäuregruppen und Maleinsäurehalbestergruppen verwendet werden.

Auch in der DE-A1 25 09 842 werden wäßrig entwickelbare Druckplatten beschrieben. Diese enthalten als Bindemittel ein in wäßrig-alkalischen Lösungen lösliches Copolymer aus ungesättigten Carbonsäuren und Hydroxyalkyl(meth)acrylaten, die u.a. auch mit cyclischen Säureanhydriden zu Halbestern umgesetzt sein können. Ähnliche Bindemittel mit zusätzlichen Amino- oder Ammoniumgruppen sind auch in der EP-A3 02 06 412 zur Herstellung von Farbfiltern beschrieben, d.h. nach dem Belichten und Auswaschen werden die Schichten mit Farbstofflösungen permanent angefärbt.

Nachteilig an den flüssigen Systemen ist u.a. ihre verfahrenstechnisch aufwendige Verarbeitung. Ein besonderer Nachteil der wäßrig entwickelbaren Druckplatten gegenüber lösungsmittelentwickelbaren Materialien ist ihre geringe Beständigkeit in alkoholischen und wäßrigen Druckfarben, wodurch Quellungen der Druckoberfläche und damit fehlerhafte Druckergebnisse hervorgerufen werden.

Beispiele für feste, lösungsmittelentwickelbare Aufzeichnungsmaterialien finden sich in den folgenden Patentschriften: DE-C3 22 15 090; US-A 4,266,005; US-A 4,320,188 und US-A 4,430,417. Solche photopolymerisierbaren Druckplatten setzen sich üblicherweise aus einem Schichtträger, ggf. einer Haft-oder anderen Unterschicht, einer photopolymerisierbaren Schicht, die mindestens ein polymeres Bindemittel, mindestens ein durch aktinische Strahlung additionspolymerisierbares, ethylenisch ungesättigtes Monomer und einen Photoinitiator oder ein Photoinitiatorsystem enthält, und einem Deckelement, bestehend aus einem biegsamen Polymerfilm, der im Entwicklerlösungsmittel löslich ist, und einer abtrennbaren Deckfolie, zusammen.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird.

Aus der EP-B1 00 84 851 ist ein Herstellungsverfahren für eine mehrschichtige, photopolymerisierbare Druckplatte bekannt, die zwischen dem biegsamen Polymerfilm des Deckelements und der photopolymerisierbaren Schicht eine elastomere Schicht besitzt, die ein elastomeres Bindemittel, ggf. ein zweites Bindemittel, ggf. einen Farbstoff, ggf. ein oder mehrer Monomere und ggf. einen Photoinitiator enthält.

Ein Nachteil der aus den beschriebenen mit Lösungsmitteln entwickelbaren Materialien hergestellten Flexodruckformen ist ihre uneinheitliche Druckqualität. So sind mit alkoholischen und wäßrigen Flexodruckfarben nur unbefriedigende Druckergebnisse zu erzielen, da in diesen Fällen eine unzureichende Farbübertragung beim Druck zu Farbfehlstellen, führt. Besonders die Übertragung der 5%-Punkte ist bei der Verwendung solcher Druckfarben fehlerhaft.

Der vorliegenden Erfindung lag daher die Aufgabe zugrunde, dieses Druckproblem zu beseitigen und feste, photopolymerisierbare Druckplatten zur Verfügung zu stellen, mit denen Flexodruckformen mit verbesserter Farbübertragung hergestellt werden können. Desweiteren sollte die übliche Auswaschentwicklung mit organischen Lösungsmitteln möglich sein. Gleichzeitig sollten andere Eigenschaften der photopolymerisierbaren Druckplatten nicht negativ beeinflußt werden, z.B. sollte eine Verringerung der Photoempfindlichkeit vermieden werden. Außerdem sollten die Flexodruckformen in den Druckfarben nicht quellen, da dies zu einem unerwünschten Punktzuwachs und damit zu fehlerhaften Druckergebnissen führt.

Diese Aufgabe wurde überraschenderweise gelöst durch eine photopolymerisierbare Druckplatte im wesentlichen bestehend aus a) einem Schichtträger, b) einer photopolymerisierbaren Schicht, enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem, c) einer elastomeren Schicht, enthaltend mindestens ein thermoplastisch elastomeres Blockcopolymer, und d) einer Deckfolie.

Die Erfindung ist dadurch gekennzeichnet, daß die elastomere Schicht c) außerdem mindestens ein Polymer mit der Struktureinheit A 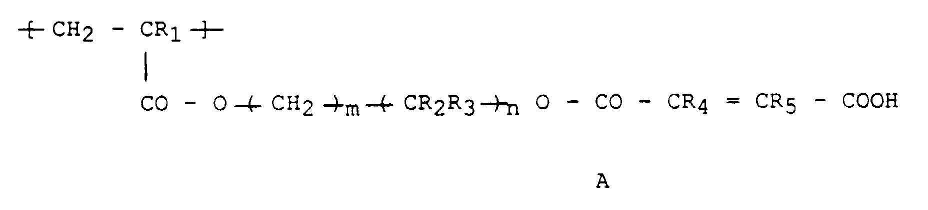 enthält, worin R₁ für H und CH₃, R² und R³ unabhängig voneinander für H und substituierte oder unsubstituierte Alkyl- oder Arylgruppen und R₄ und R₅ unabhängig voneinander für H und substituierte oder unsubstituierte Alkygruppen stehen können und m und n Werte von 0 bis 10 annehmen können, wobei die Summe aus m und n gleich 2 bis 20 sein kann.

Überraschend war, daß die relativ polaren, erfindungswesentlichen Polymere mit den thermoplastisch elastomeren Blockcopolymeren der elastomeren Schicht c) ausreichend verträglich sind. Der Fachmann hätte erwartet, daß diese Polymere miteinander unverträglich sind oder zumindest nur eine begrenzte Verträglichkeit aufweisen und daß aufgrund dessen die erfindungsgemäßen Polymere beim Kalandrieren der verschiedenen Schichten einer photopolymerisierbaren Druckplatte aufeinander aus der elastomeren Schicht ausschwitzen. Zudem war auch zu erwarten, daß sich die Schichten der Druckplatte bzw. -formen aufgrund der Unverträglichkeit der erfindungsgemäßen Polymere mit den übrigen Komponenten voneinander ablösen würden. Entgegen den Erwartungen weisen die neuen Flexodruckplatten und -formen jedoch eine hohe Stabilität und gleichmäßige Eigenschaften auf.

Desweiteren war es erstaunlich, daß die übliche Entwicklung mit organischen Lösungsmitteln ohne besondere Zusätze möglich ist, obwohl die erfindungswesentlichen Polymere ein ganz anderes Lösungsverhalten als die übrigen Komponenten der photopolymerisierbaren Druckplatte besitzen, wie der o.g. Einsatz strukturähnlicher Polymere in wäßrig entwickelbaren Materialien belegt. Auch ist überraschenderweise kein Auswaschen der erfindungswesentlichen Polymere und keine Quellung der erfindungsgemäß hergestellten Druckformen mit polaren Flexodruckfarben zu beobachten, wie es der Fachmann aufgrund der Erfahrungen mit wäßrig entwickelbaren Druckplatten erwartet hätte.

Auch eine störende Farbaufnahme und Anfärbbarkeit der Druckoberfläche wurde entgegen diesbezüglicher Befürchtungen aufgrund der Verwendung zu den erfindungswesentlichen Polymeren strukturell ähnlichen Verbindungen in Materialien zur Herstellung von Farbfiltern, nicht beobachtet. Im Gegenteil, das Druckverhalten lösungsmittelentwickelbarer Druckformen für den Flexodruck konnte durch den Zusatz der erfindungsgemäßen Polymere zur elastomeren Schicht c) erheblich verbessert werden und auch ihre Ozonstabilität konnte erhöht werden.

Das Wesentliche der erfindungsgemäßen Polymere ist die Struktureinheit A.

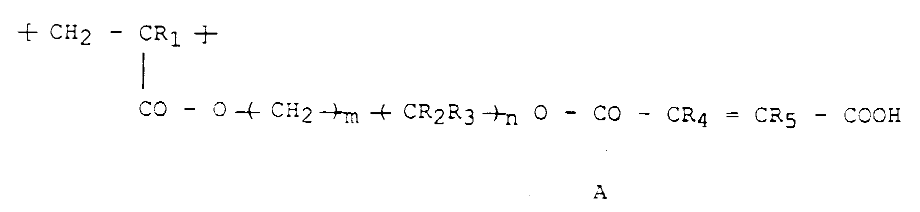

Der Rest R₁ steht hierbei für H und CH₃, so daß das Polymergerüst aus Acryl- oder Methacrylsäureeinheiten aufgebaut ist. R₂ und R₃ können unabhängig voneinander H und substituierte oder unsubstituierte Alkyl- oder Arylgruppen sein, und m und n können Werte von 0 bis 10 annehmen, wobei die Summe aus m und n gleich 2 bis 20 sein sollte. Bevorzugt werden für R₂ und R₃ H und unsubstituierte Alkylgruppen und für m und n Werte von 1 bis 8 verwendet; besonders bevorzugt sind H und Alkylgruppen mit 1 bis 5 Kohlenstoffatomen und Werte für m und n von 1 bis 5. R₄ und R₅ können unabhängig voneinander H und substituierte und unsubstituierte Alkylgruppen sein, bevorzugt werden H und unsubstituierte Alkylgruppen verwendet, besonders bevorzugt H und Alkylgruppen mit 1 bis 6 Kohlenstoffatomen.

Die erfindungsgemäßen Polymere können zu 100 Gew.% aus der Struktureinheit A bestehen. Es können aber auch Copolymere, die zu 50 - 95 Gew.%, bzw. bevorzugt zu 75 - 95 Gew.% aus A bestehen, verwendet werden.

Als Comonomere sind Acrylate, Methacrylate, ethylenisch ungesättigte Aromaten und Kohlenwasserstoffe mit konjugierten Doppelbindungen geeignet.

Die erfindungsgemäßen Polymere sind zu 5 bis 30 Gew.% in der elastomeren Schicht c) enthalten. Werden weniger als 5 Gew.% eingesetzt, ist keine wesentliche Verbesserung der Druckqualität zu beobachten, werden mehr als 30 Gew.% verwendet, so ist die Resistenz der Flexodruckformen gegenüber alkoholischen und wäßrigen Flexodruckfarben zu gering und dies führt zur Quellung der Druckoberfläche und damit zu Punktzuwachs. Werden Polymere verwendet, die nur aus der Struktureinheit A aufgebaut sind, so werden bevorzugt 10 bis 20 Gew.%, besonders bevorzugt 10 bis 15 Gew.% eingesetzt. Werden Copolymere mit den o.g. Comonomeren verwendet, so werden bevorzugt 15 bis 30 Gew.%, besonders bevorzugt 18 bis 25 Gew.% eingesetzt.

Die elastomere Schicht c) enthält als Bindemittel zu 50 - 95 Gew. % mindestens eines thermoplastischen elastomeren Blockcopolymer, wie sie z.B.in der EP-B1 00 84 851 genannt werden. Das mittlere Molekulargewicht der Blockcopolymere sollte über 80 000, bevorzugt über 100 000, liegen. Bevorzugt werden Blockcopolymere mit 10 bis 30 Gew.%, besonders bevorzugt 10 bis 20 Gew.%, Polystyrolendblöcken verwendet. Insbesondere 2-Block- und 3-Blockcopolymere mit Polystyrol- und Polybutadien- bzw. Polyisoprenblöcken werden bevorzugt. Vor allem radiale (Polystyrol-Polybutadien)₄-Si-Blockcopolymere, wie z..B. mit einem Polystyrolgehalt von 10 bis 30 Gew.% können als Bindemittel eingesetzt werden.

Zusätzlich können in der elastomeren Schicht c) 0 bis 40 Gew.% weiterer Polymere, bevorzugt thermoplastischer Polymere, enthalten sein. Als Beispiele seien genannt Polymere und Copolymere aus Methylmethacrylat/Acrylnitril/Butadien/Styrol, Styrol/Methylmethacrylat, Acrylnitril/Butadien/Styrol, Butadien, Isopren, Chloropren, Styrol/Butadien, Styrol/Isopren oder Mischungen hieraus. Besonders geeignet sind thermoplastische Polymere mit einer Trübung (gemäß ASTM D 1003) von ≤ 20 %., bevorzugt ≤ 12 % und einer Rockwell Härte gemessen nach ASTM D 785 von ≥ 50, bevorzugt ≥ 80.

Als weitere übliche Zusätze können Farbstoffe, Füllstoffe, Weichmacher, Lösungsmittel, etc. verwendet werden wie sie in der EP-B1 00 84 851 genannt werden.

Die elastomere Schicht c) sollte eine Dicke von 0,01 bis 0,5 mm, bevorzugt 0,025 bis 0,12 mm, haben.

Die Schicht kann durch Gießen aus Lösungsmitteln wie Toluol, Aceton, Methylenchlorid, Perchlorethylen, Methylethylketon, Methylisobutylketon oder Mischungen etc. oder durch Extrusionsbeschichtung direkt auf die Deckfolie d), z.B. eine Polyethylenterephthalatfolie, oder auf eine auf der Deckfolie d) befindliche biegsame, polymere Folie e) aufgebracht werden. Wenn das thermoplastische Polymer nicht wie üblich gemeinsam mit anderen Komponenten zur Herstellung der Gießlösung für die elastomere Schicht c) in einem entsprechenden Lösungsmittel aufgelöst wird, sondern vorher separat im Lösungsmittel gelöst und diese Lösung vorfiltriert wird und dann diese Lösung zu einer Lösung der übrigen Gießkomponenten gegeben wird, so ist eine erhebliche Verbesserung der Gießqualität zu erzielen. Die 0,0025 mm bis 0,04 mm dicke polymere Folie e) ist im Entwicklerlösungsmittel für die photopolymerisierbare Schicht b) löslich oder zumindest mit diesem strippbar und besteht bevorzugt aus einem Polyamid, einem Copolymer aus Ethylen und Vinylacetat oder ähnlichen Polymeren.

Die erfindungswesentlichen Polymere mit der Struktureinheit A können als fertige Polymere der Gieß- bzw. Extrusionsmischung zur Herstellung der Schicht c) zugesetzt werden. Sie können aber auch nach dem Vergießen oder Extrudieren einer elastomeren Mischung, die die entsprechenden Mengen Ausgangsmonomere der erfindungsgemäßen Polymere und einen Photoinitiator enthält durch diffuse Belichtung einer solchen Schicht mit aktinischer Strahlung direkt in dieser Schicht hergestellt werden.

Die photopolymerisierbare Schicht b) der erfindungsgemäßen Druckplatten enthält mindestens ein elastomeres Bindemittel. Geeignet sind z.B. Blockcopolymere wie sie in DE-C3 22 15 090; US-A 4,320,188 und US-A 4,162,919 beschrieben werden. Bevorzugt werden Blockcopolymere vom A-B-A-Typ, die einen elastomeren Block, z.B. Polybutadien oder Polyisopren, zwischen zwei thermoplastischen Blöcken, z.B. Polystyrol, besitzen. Besonders bevorzugt werden lineare und radiale Blockcopolymere mit Polystyrol-Endblöcken verwendet, wie z.B. Polystyrol-Polyisopren-Polystyrol,, (Polystyrol-Polybutadien)4 Si oder (Polystyrol-Polyisopren)4 Si.
Das mittlere Molekulargewicht der Blockcopolymere sollte zwischen 80 000 und 300 000 liegen, bevorzugt zwischen 100 000 und 250 000. Der Polystyrolanteil sollte 10 bis 40 Gew.% betragen, bevorzugt 15 bis 30 Gew.%.

Die photopolymerisierbare Schicht b) enthält außerdem mindestens ein durch aktinische Strahlung additionspolymerisierbares, ethylenisch ungesättigtes Monomer. Hierbei kann es sich sowohl um Monomere mit einer ethylenisch ungesättigten Gruppe als auch um solche mit mehreren ethylenisch ungesättigten Gruppen handeln. Die Monomere können allein oder auch in Kombination miteinander eingesetzt werden. Bevorzugt werden Monomermischungen aus einfach ungesättigten Acrylaten und/oder Methacrylaten und mehrfach ungesättigten Acrylaten und/oder Methacrylaten verwendet. Solche Monomermischungen werden in der DE-C1 37 44 243 beschrieben.

Als Beispiel seien genannt; Octylacrylat, Isodecylacrylat, Isodecylmethacrylat, 2-Hexyloxyethylacrylat, 1,4-Butandioldiacrylat, 1,6-Hexandioldiacrylat, 1,6-Hexandioldimethacrylat, Trimethylolpropantriacrylat.

Außerdem enthält die photopolymerisierbare Schicht b) einen Photoinitiator oder ein Photoinitiatorsystem, z.B.:
α-Methylbenzoin, Benzophenon, Benzil-dimethyl-ketal oder Ethylanthrachinon/4,4'-Bis-(dimethylamino)-benzophenon. Ferner kann die photopolymerisierbare Schicht b) weitere Zusätze enthalten, wie z.B. Füllstoffe, Farbstoffe, Antioxidantien und Plastifizierungsmittel wie sie in EP-B1 00 84 851 genannt werden. Bevorzugt werden 0 - 30 Gew.% an Plastifizierungsmittel z.B. auf der Basis von Polystyrol bzw. Polybutadien und mit einem mittleren Molekulargewicht zwischen 1 000 und 10 000 verwendet.
Die photopolymerisierbare Schicht b) enthält allgemein 65 - 95 Gew.% Bindemittel, 5 - 30 Gew.% Monomer oder Monomermischung und 0,5 - 5 Gew.% Initiator.

Als Schichtträger a) eignen sich z.B. Aluminium, Stahl oder Kunststoffolien. Bevorzugt werden Polyesterfolien, die ggf. mit einer Haftschicht und/oder Antihaloschicht versehen sein können. Besonders geeignet sind Polyethylenterephthalatfolien.

Die erfindungsgemäßen, photopolymerisierbaren Druckplatten werden bevorzugt nach dem in der EP-B1 00 84 851 beschriebenen Verfahren hergestellt. Hierbei wird eine vorher extrudierte photopolymerisierbare Masse in den Spalt eines Kalanders eingeführt und zwischen einen Träger und ein Deckelement, bestehend aus einer Deckfolie d), ggf. einer biegsamen Folie e) und der erfindungsgemäßen Schicht c) kalandriert, wodurch eine photopolymerisierbare Schicht gebildet wird, die auf ihrer einen Seite an den Schichtträger und auf der anderen Seite an die elastomere Schicht c) des Deckelements angrenzt.

Die so hergestellte photopolymerisierbare Druckplatte wird abgekühlt und ggf. einer Vorbelichtung mit aktinischer Strahlung durch den Schichtträger hindurch unterworfen. Dann wird üblicherweise die Deckfolie entfernt, ein bildtragendes Transparent auf die photopolymerisierbare Druckplatte aufgelegt und durch dieses mit aktinischer Strahlung belichtet. Daraufhin wird die ggf. vorhandene biegsame, polymere Folie e) und die unvernetzten Bereiche der photopolymerisierbaren Schicht b) und der elastomeren Schicht c) durch Auswaschen mit einem Entwicklerlösungsmittel entfernt. Hierfür eignen sich besonders organische Lösungsmittel wie chlorierte Kohlenwasserstoffe, z.B. 1,1,1-Trichlorethan, oder gesättigte oder aromatische Kohlenwasserstoffe, die ggf. mit Alkoholen wie z.B. n-Butanol vermischt sein können. Bevorzugt werden die Lösungsmittel der deutschen Patentanmeldung P 38 28 551.7 verwendet. Zur Entwicklung kann das Lösungsmittel in beliebiger Weise aufgebracht werden, z.B. durch Gießen, Tauchen, Spritzen oder Walzenauftrag. Durch Bürsten wird die Entfernung der nicht vernetzten Schichtteile erleichtert. Nach dem Trocknen der so erhaltenen Druckformen bei 40 bis 75°C können diese in beliebiger Reihenfolge nachbelichtet und/oder zur Herstellung einer klebfreien Oberfläche z.B. mit einer freies Halogen enthaltenden Lösung behandelt werden.
Die in den folgende Beispielen angegebenen Prozente und Teile beziehen sich, soweit nicht anders angegeben, auf das Gewicht.

### Beispiel 1 (Vergleichsbeispiel)

| | |
|---|---|
| Polystyrol-Polyisopren-Polystyrol Blockcopolymer 15% Polystyrol, Brookfield Viskosität 1600 mPa s (25%ig in Toluol) | 67,4 % |
| Methylmethacrylat/Acrylnitril/Butadien/Styrol Tetrapolymer, 46/9/14/31 | 31,3 % |
| Acid Blue (C.I 13390) | 1,3 % |

Zur Herstellung eines mehrschichtigen Deckelements wurden der Farbstoff und das Tetrapolymer bei 116° C zusammengeknetet und dann extrudiert und granuliert. Dieses Gemisch und die übrigen Inhaltsstoffe der elastomeren Schicht c) wurden dann zu einer 15%igen Lösung in Methylenchlorid verarbeitet. Diese Gießlösung wurde mittels eines Extrusionsschlitzgießers mit einer Spaltbreite von 0,38 mm auf die Polyamidbeschichtung einer Polyethylenterephthalatunterlage, wie in EP-B1 00 84 851 Beispiel 1 beschrieben, aufgetragen, getrocknet und mit einer siliconbeschichteten Polyethylenterephthalatschutzschicht versehen.Die Trockenschichtdicke betrug 0.051 mm. Zur Herstellung einer Flexodruckplatte wurde analog EP-B1 00 84 851, Beispiel 1, eine photopolymerisierbare Mischung aus 1,4 Teilen 2,2-Dimethoxy-2-phenylacetophenon, 5,3 Teilen Hexamethylenglykoldiacrylat, 3,7 Teilen Hexamethylenglykoldimethacrylat, 0,166 Teilen 2,6-Di-tert-butyl-p-kresol, 0,001 Teilen Hydrochinon, 0,003 Teilen roter Farbstoff (C.I. 109), 0,13 Teilen Hydroxyethylmethacrylat, 82,3 Teilen Polystyrol-Polyisopren-Polystyrol Blockcopolymer (15% Polystyrol, MG 150 000), 6 Teilen α-Methylstyrol/Vinyltoluol-Harz und 1 Teil mikrokristallines Kohlenwasserstoffwachs in einem Zweischneckenextruder hergestellt, extrudiert und zwischen eine Polyethylenterephthalatträgerschicht und die elastomere Schicht c) des o.g. Deckelements, nachdem die Polyethylenterephthalatschutz-schicht entfernt war, kalandriert. Nach dem Abkühlen, der vollflächigen Rückseitenbelichtung durch die Trägerschicht und dem Entfernen der Polyethylenterephthalatdeckschicht wurde ein bildtragendes Transparent auf die Polyamidschicht aufgelegt und hierdurch die Druckplatte 6 Minuten mit aktinischer Strahlung belichtet. Die Entwicklung der photopolymerisierten Druckplatte erfolgte durch Auswaschen mit einem Tetrachlorethylen/n-Butanol Gemisch (75/25 Vol.%), wobei die Polyamidschicht und die unbelichteten Teile der photopolymerisier-baren Schicht b) und der elastomeren Schicht c) entfernt wurden. Anschließend wurde die Flexodruckform analog zu EP-B1 00 84 851 Beispiel 1 getrocknet, mit wäßriger Hypochloritlösung behandelt und nachbelichtet.

### Beispiel 2

### Zusammensetzung der elastomeren Schicht c)

| | |
|---|---|
| Polystyrol-Polyisopren-Polystyrol Blockcopolymer 15% Polystyrol, Brookfiled Viskosität 1600 mPa s (25%ig in Toluol) | 58,7 % |
| Methylmethacrylat/Acrylnitril/Butadien/Styrol Tetrapolymer, 46/9/14/31 | 27,3 % |
| Acid Blue (C.I. 13390) | 1,2 % |
| Maleinsäure-mono-2-acryloyloxyethylester | 11,6 % |
| Benzildimethylketal | 1,16 % |
| Hydrochinon | 0,04 % |

Eine 17%ige Lösung in Methylenchlorid wurde wie in Beispiel 1 zur elastomeren Schicht c) verarbeitet. Nach dem Trocknen wurde die Schicht mit einer UV-Lampe (180-Watt-Hochdruck-Quecksilber-Lampe) 1 Minute diffus belichtet, bevor sie auf eine lichtempfindliche Flexodruckplatte wie in Beispiel 1 auflaminiert wurde. Die weitere Verarbeitung der so hergestellten Druckplatte erfolgte wie in Beispiel 1 beschrieben. Die Photoempfindlichkeit, der Belichtungsspielraum und das Entwicklungsverhalten entsprach der Druckplatte von Beispiel 1.

### Beispiel 3

### Zusammensetzung der elastomeren Schicht c)

| | |
|---|---|
| Polystyrol-Polyisopren-Polystyrol Blockcopolymer 15% Polystyrol, Brookfield Viskosität 1600 mPa s (25%ig in Toluol) | 58,7 % |
| Methylmethacrylat/Acrylnitril/Butadien/Styrol Tetrapolymer, 46/9/14/31 | 27,3 % |
| Acid Blue (C.I. 13390) | 1,2 % |
| Maleinsäure-mono-2-methacryloyloxyethylester | 11,6 % |
| Benzildimethylketal | 1,16 % |
| Hydrochinon | 0,04 % |

Die Herstellung der elastomeren Schicht und alle weiteren Verarbeitungsschritte erfolgten wie in Beispiel 2. Die Photoempfindlichkeit, der Belichtungsspielraum und das Entwicklungsverhalten entsprach der Druckplatte von Beispiel 1.

### Beispiel 4

a) Polymethacrylsäurehydroxypropylester und
Maleinsäureanhydrid (1:1) wurden 2 h in Dimethylsulfoxid als Lösungsmittel auf 80° C erhitzt. Das entsprechende Monomaleat wurde durch Zugabe von Wasser ausgefällt und anschließend getrocknet.
b) Zusammensetzung der elastomeren Schicht c)

| | |
|---|---|
| Polystyrol-Polyisopren-Polystyrol Blockcopolymer 15% Polystyrol, Brookfield Viskosität 1600 mPa s (25%ig in Toluol) | 57,4 % |
| Methylmethacrylat/Acrylnitril/Butadien/Styrol Tetrapolymer, 46/9/14/31 | 26,7 % |
| Acid Blue (C.I. 13390) | 1,1 % |
| nach a) hergestelltes Polymer | 14,8 % |

Eine 17%ige Lösung in Toluol/Dimethylformamid (9:1) wurde wie in Beispiel 1 zur elastomeren Schicht c) verarbeitet. Auch die weitere Behandlung erfolgte wie in Beispiel 1. Die Photoempfindlichkeit, der Belichtungsspielraum und das Entwicklungsverhalten entsprach der Druckplatte von Beispiel 1.

### Beispiel 5

### Zusammensetzung der elastomeren Schicht c)

| | |
|---|---|
| Polystyrol-Polyisopren-Polystyrol Blockcopolymer 15% Polystyrol, Brookfield Viskosität 1600 mPa s (25%ig in Toluol) | 58,1 % |
| Methylmethacrylat/Acrylnitril/Butadien/Styrol Tetrapolymer, 46/9/14/31 | 27,9 % |
| Acid Blue (C.I. 13390) | 1,2 % |
| Maleinsäure-mono-2-acryloyloxyethylester | 11,6 % |
| Benzildimethylketal | 1,16 % |
| Hydrochinon | 0,04 % |

Diese Inhaltsstoffe der elastomeren Schicht c) wurden zusammengeknetet und auf die Polyamidbeschichtung einer Polyethylenterephthalatunterlage extrudiert. Die weitere Verarbeitung erfolgte wie in Beispiel 2 beschrieben. Die Photoempfindlichkeit, der Belichtungsspielraum und das Entwicklungsverhalten entsprach der Druckplatte von Beispiel 1.

### Beispiel 6

### Zusammensetzung der elastomeren Schicht c

| | |
|---|---|
| radiales Poylystyrol-Polybutadien-Polystyrol Blockcopolymer | 56 % |
| 30 % Polystyrol, Lösungsviskosität 9,1 mm²/s (5.23 %ig in Toluol) | |
| Methylmethacrylat/Acrylnitril/Butadien/Styrol | 28 % |
| Acid Blue (C.I. 13390) | 1% |
| Maleinsäure-mono-2-methacryloyloxyethylester | 13 % |
| Benzildimethylketal | 1.9 % |
| Hydrochinon | 0.1 % |

Die Herstellung der elastomeren Schicht und alle weiteren Verarbeitungsschritte erfolgten wie in Beispiel 2. Die Photoempfindlichkeit, der Belichtungsspielraum und das Entwicklungsverhalten entsprach der Druckplatte von Beispiel 1.

### Drucktest

Die Druckversuche wurden auf einer weiß pigmentierten Polyethylenfolie mit einer alkoholischen Flexodruckfarbe (CYAN, Viskosität 29 mPa· sec/DIN 53211) durchgeführt, wobei eine Flexo-Druckmaschine mit einer Rasterwalze mit 170 Linien/cm and 5 g /m³ bei einer Druckgeschwindigkeit von 80 m/min verwendet wurde.

Die erfindungsgemäßen Druckplatten zeigen höhere Volltondichten und bessere Wiedergabe von Linien und Vollflächen als das Vergleichsmaterial.

## Patentansprüche

1. Photopolymerisierbare Druckplatte im wesentlichen bestehend aus
a) einem Schichtträger,
b) einer photopolymerisierbaren Schicht enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem,
c) einer elastomeren Schicht enthaltend mindestens ein thermoplastisch elastomeres Blockcopolymer
und
d) einer Deckfolie,
dadurch gekennzeichnet, daß
die elastomere Schicht c) außerdem mindestens ein Polymer mit der Struktureinheit A 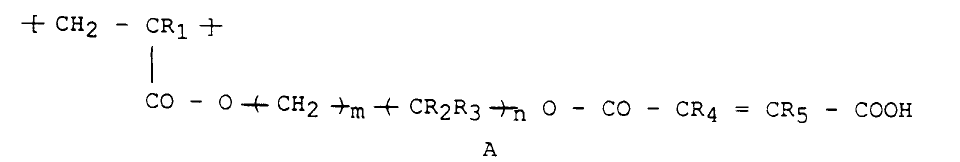 enthält, worin
R₁ für H und CH₃, R₂ und R₃, unabhängig voneinander für H und substituierte oder unsubstituierte Alkyl- oder Arylgruppen und R₄ und R₅ unabhängig voneinander für H und substituierte oder unsubstituierte Alkylgruppen stehen können und m und n Werte 0 bis 10 annehmen können, wobei die Summe aus m und n gleich 2 bis 20 ist.

2. Photopolymerisierbare Druckplatte nach Anspruch 1
dadurch gekennzeichnet, daß
die elastomere Schicht c) 5 bis 30 Gew.% des Polymeren mit der Struktureinheit A enthält.

3. Photopolymerisierbare Druckplatte nach Anspruch 1 oder 2
dadurch gekennzeichnet, daß
die elastomere Schicht c) durch vollflächige Belichtung einer photopolymerisierbaren Schicht erhalten wird, die mindestens eine Verbindung der Formel B 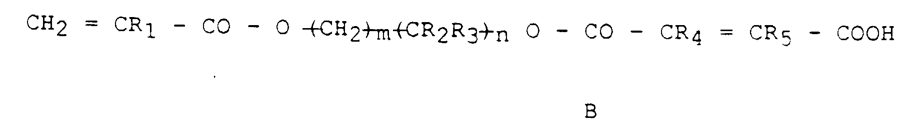 enthält, worin
R₁ für H und CH₃, R₂ und R₃, unabhängig voneinander für H und substituierte oder unsubstituierte Alkyl- oder Arylgruppen und R₄ und R₅ unabhängig voneinander für H und substituierte oder unsubstituierte Alkylgruppen stehen können und m und n Werte 0 bis 10 annehmen können, wobei die Summe aus m und n gleich 2 bis 20 ist.

4. Photopolymerisierbare Druckplatte nach Anspruch 1 bis 3
dadurch gekennzeichnet, daß
die elastomere Schicht c) 50 - 95 Gew.% eines thermoplastischen elastomeren Blockcopolymers mit einem Polystyrolgehalt von 10 bis 30 Gew.% enthält.

5. Photopolymerisierbare Druckplatte nach Anspruch 1 bis 4
dadurch gekennzeichent, daß
die elastomere Schicht c) mindestens ein radiales (Polystyrol-Polybutadien)4 Si Blockcopolymer mit einem Polystyrolgehalt von 15 - 30 Gew.% enthält.

6. Photopolymerisierbare Druckplatte nach Anspruch 1 bis 5
dadurch gekennzeichnet, daß
die elastomere Schicht c) 0 - 40 Gew.% eines Polymers mit einer Trübung von ≤ 20 %, gemessen nach ASTM D 1003 und einer Rockwell Härte gemessen nach ASTM D 785 von ≥ 50, enthält.

7. Photopolymerisierbare Druckplatte nach Anspruch 1 bis 6
dadurch gekennzeichnet, daß
sie zwischen der elastomeren Schicht c) und der Deckfolie d) eine biegsame polymere Folie e) enthält.

8. Verfahren zur Herstellung der elastomeren Schicht c) einer photopolymerisierbaren Druckplatte gemäß Anspruch 6,
dadurch gekennzeichnet, daß
das thermoplastische Polymer im Lösungsmittel für die Gießlösung aufgelöst und diese Lösung filtriert wird und dann aus den übrigen Komponenten und der so vorbehandelten Lösung des Polymeren die Gießlösung für die elastomere Schicht c) hergestellt wird.

9. Verfahren zur Herstellung photopolymerisierbarer Druckplatten, bei dem in den Spalt eines Kalanders eine photopolymerisierbare Masse aus mindestens einem elastomeren Bindemittel, mindestens einem durch aktinische Strahlung additionspolymerisierbaren, ethylenisch ungesättigten Monomer und einem Photoinitiator oder einem Photoinitiatorsystem eingeführt und zwischen einen Träger a) und ein mehrschichtiges Deckelement kalandriert wird und die photopolymerisierbare Schicht b) zwischen ihnen gebildet wird, wobei das mehrschichtige Deckelement im wesentlichen aus einer elastomeren Schicht c) enthaltend mindestens ein thermoplastisch elastomeres Blockcopolymer, und einer Deckfolie d) besteht
dadurch gekennzeichnet, daß
die elastomere Schicht c), mindestens ein Polymer mit der Struktureinheit A 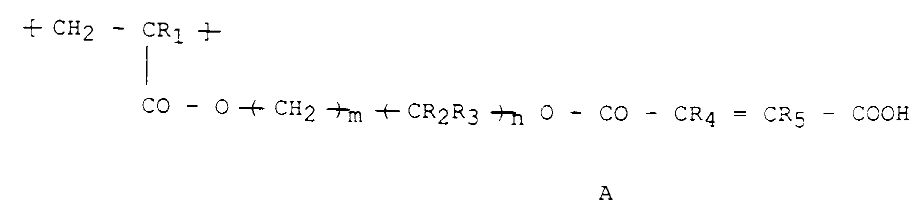 enthält, worin
R₁ für H und CH₃, R₂ und R₃, unabhängig voneinander für H und substituierte oder unsubstituierte Alkyl- oder substituierte oder unsubstituierte Alkylgruppen stehen können und m und n Werte 0 bis 10 annehmen können, wobei die Summe aus m und n gleich 2 bis 20 sein kann.

10. Verfahren zur Herstellung von flexographischen Druckformen umfassend
1) das bildmäßige Belichten mit aktinischer Strahlung einer photopolymerisierbaren Druckplatte gemäß Anspruch 1 bis 7
a) durch die Deckfolie d) oder
b) nach Entfernen der Deckfolie d) durch die elastomere Schicht c) oder
c) nach Entfernen der Deckfolie d) durch eine biegsame polymere Folie e), falls diese in der photopolymerisierbaren Druckplatte zwischen elastomerer Schicht c) und Deckfolie d) vorhanden ist, und
2) das Entfernen der biegsamen, polymere Folie e), falls vorhanden, und der unbelichteten Bereiche der photopolymerisierbaren Schicht b) und der elastomeren Schicht c) durch Auswaschen mit Entwicklerlösungsmitteln.

## Claims

1. A photopolymerizable printing element consisting essentially of
a) a support;
b) a photopolymerizable layer containing at least one elastomeric binder, at least one ethylenically unsaturated monomer addition-polymerizable by actinic radiation, and a photoinitiator or photoinitiator system;
c) an elastomeric layer containing at least one thermoplastic, elastomeric block copolymer; and
d) a cover sheet
characterized in that,
the elastomeric layer c) further contains at least one polymer with the structural unit A: 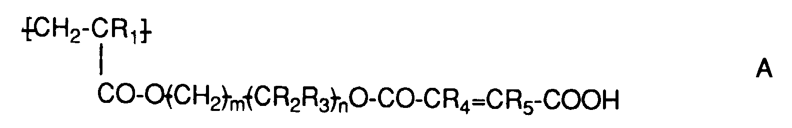 wherein R₁ is H and CH₃, R₂ and R₃ can be the same or different and are H and substituted or unsubstituted alkyl or aryl groups, R₄ and R₅ can be the same or different and are H and substituted or unsubstituted alkyl groups, and m and n have values 0 to 10, whereby the sum of m and n is equal 2 to 20.

2. A photopolymerizable printing element according to Claim 1,
characterized in that,
the elastomeric layer c) contains 5 to 30 percent by weight of a polymer with the structural unit A.

3. A photopolymerizable printing element according to Claim 1 or 2,
characterized in that,
the elastomeric layer c) is obtained by exposing overall a photopolymerizable layer containing at least one compound of formula B:
CH₂=CR₁-CO-O(CH₂)ₘ(CR₂R₃)ₙO-CO-CR₄=CR₅-COOH
wherein R₁ is H and CH₃, R₂ and R₃ can be the same or different and are H and substituted or unsubstituted alkyl or aryl groups, R₄ and R₅ can be the same or different and are H and substituted or unsubstituted alkyl groups, and m and n have values 0 to 10, whereby the sum of m and n is equal 2 to 20.

4. A photopolymerizable printing element according to Claim 1 - 3,
characterized in that,
the elastomeric layer c) contains 50 to 95 percent by weight of a thermoplastic, elastomeric block copolymer having a polystyrene content of 10 - 30 percent by weight

5. A photopolymerizable printing element according to Claim 1 - 4,
characterized in that,
the elastomeric layer c) contains at least one radial (polystyrene/polybutadiene)₄Si block copolymer having a polystyrene content of 15 - 30 percent by weight.

6. A photopolymerizable printing element according to claims 1 -5
characterized in that,
the elastomeric layer c) contains 0 - 40 percent by weight of a polymer having a turbidity measured according to ASTM D 1003 ≤ 20%, and a Rockwell hardness measured according to ASTM D 785 ≥ 50.

7. A photopolymerizable printing element according to claims 1 - 6
characterized in that,
wherein a flexible polymeric sheet e) is interposed between the elastomeric layer c) and the cover sheet d).

8. A process for preparing the elastomeric layer c) of a photopolymerizable printing element according to claim 6,
characterized in that,
the thermoplastic polymer is dissolved in the solvent for the coating solution and this solution is filtered and then the coating solution for the elastomeric layer c) is made up from the remaining components and the in such a way pretreated solution.

9. A process for preparing photopolymerizable printing elements comprising feeding into the nip of a calender a photopolymerizable composition containing at least one elastomeric binder, at least one ethylenically unsaturated monomer addition-polymerizable by actinic radiation and a photoinitiator or a photoinitiator system, calendering the composition between a support a) and a multilayer cover element to form the photopolymerizable layer b) between them, wherein the multilayer cover element consists essentially of an elastomeric layer c) containing at least one
thermoplastic, elastomeric block copolymer, and a cover sheet d)
characterized in that,
the elastomeric layer c) contains at least one polymer having the structural A: 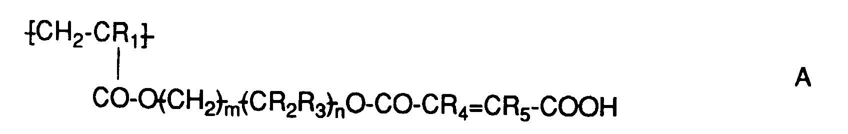 wherein R₁ is H and CH₃, R₂ and R₃ can be the same or different and are H and substituted or unsubstituted alkyl or aryl groups, R₄ and R₅ can be the same or different and are H and substituted or unsubstituted alkyl groups, and m and n have values 0 to 10, whereby the sum of m and n can be equal 2 to 20.

10. A process for preparing flexographic printing plates comprising:
1) exposing imagewise the photopolymerizable element of claim 1 - 7
a) through the cover sheet d), or
b) after removal of the cover sheet d), through the elastomeric layer c), or
c) after removal of cover sheet d), through a flexible polymeric sheet e), if it is present in the photopolymerizable plate between elastomeric layer c) and cover sheet d); and
2) removing the flexible, polymeric sheet e), if present, and the unexposed areas of the photopolymerizable layer b), and of the elastomeric layer c) by washoff with developer solvents.

## Revendications

1. Cliché photopolymérisable composé pour l'essentiel de
a) un support de couche:
b) une couche photopolymérisable contenant au moins un liant élastomère, au moins un monomère éthyléniquement insaturé susceptible d'une polymérisation par addition sous l'effet de rayonnement actinique et un photo-initiateur ou un système de photo-initiateur,
c) une couche élastomère contenant au moins un copolymère séquencé élastomère thermoplastique.
et
d) un film de recouvrement,
caractérisé en ce que la couche élastomère c) contient au moins un polymère avec le motif A. 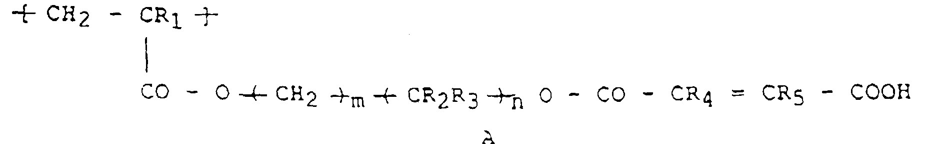 dans lequel R₁ peut représenter H et CH₃, R₂ et R₃ peuvent représenter indépendamment l'un de l'autre H et des groupes alkyle ou aryle substitués ou non substitués et R₄ et R₅ peuvent représenter indépendamment l'un de l'autre H et des groupes alkyle substitués ou non substitués et m et n peuvent prendre une valeur de 0 à 10, la somme de m et n étant égale à 2 à 20.

2. Cliché photopolymérisable selon la revendication 1, caractérisé en ce que la couche élastomère c) comprend 5 à 30 % en poids du polymère comportant le motif A.

3. Cliché photopolymérisable selon une quelconque des revendications 1 ou 2, caractérisé en ce que la couche elastomère c) est obtenue par exposition à la lumière de toute la surface d'une couche photopolymérisable comprenant au moins un composé de formule B 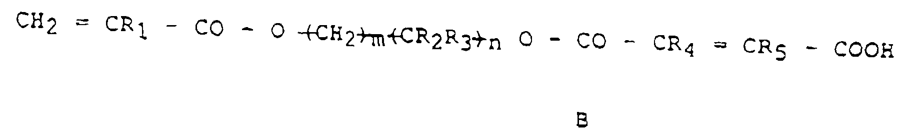 dans laquelle R₁ peut représenter H et CH₃, R₂ et R₃ peuvent représenter indépendamment l'un de l'autre H et des groupes alkyle et aryle substitués ou non substitués et R₄ et R₅ peuvent représenter indépendamment l'un de l'autre H et des groupes alkyle substitués ou non substitués et m et n peuvent prendre une valeur de 0 à 10, la somme de m et n étant égale à 2 à 20.

4. Cliché photopolymèrisable selon une quelconque des revendications 1 à 3, caractérisé en ce que la couche élastomère c) contient 50-95 % en poids d'un copolymère séquencé élastomère thermoplastique ayant une teneur en polystyrène de 10 à 30 % en poids.

5. Cliché photopolymérisable selon une quelconque des revendications 1 à 4, caractérisé en ce que la couche élastomère c) contient au moins un copolymère séquence radial de (polystyrène-polybutadiène)₄ Si élastomère thermoplastique ayant une teneur en polystyrène de 15 à 30 % en poids.

6. Cliché photopolymérisable selon une quelconque des revendications 1 à 5, caractérisé en ce que la couche élastomère c) contient 0 à 40 % en poids d'un polymère d'une turbidité ≤ 20 %, mesurée selon ASTM D 1003 et d'une dureté Rockwell ≥ 50, mesurée selon ASTM D 785.

7. Cliché photopolymérisable selon une quelconque des revendications 1 à 6, caractérisé en ce qu'il contient, entre la couche élastomère c) et le film de recouvrement d), un film polymère souple e).

8. Procédé dc fabrication d'une couche élastomère c) d'un cliché photopolymérisable selon la revendication 6, caractérisé en ce que le polymère thermoplastique est dissous dans un solvant pour la solution de coulée et que cette solution est filtrée et en ce qu'on fabrique la solution de coulée pour la couche élastomère c) à partir des autres composants et de la solution ainsi prétraitée.

9. Procédé de fabrication d'un cliché photopolymérisable dans lequel une masse pbotopolymérisable d'au moins d'un liant élastomère, au moins d'un monomère éthyléniquement insaturé susceptible d'une polymérisation par addition sous l'effet de rayonnnement actinique et un photo-initiateur ou un système de photo-initiateurs, est introduit dans l'emprise d'une calandre et qu'elle est calandrée entre un support a) et un élément de recouvrement multicouche et que la couche photopolymérisable b) est formée entre eux, l'élément de recouvrement multicouche étant constitué pour l'essentiel de la couche élastomère c) contenant au moins un polymère séquencé élastomère thermoplastique et d'un film de recouvrement d).
caractérisé en ce que
la couche élastomère c) contient au moins un polymère avec le motif A, 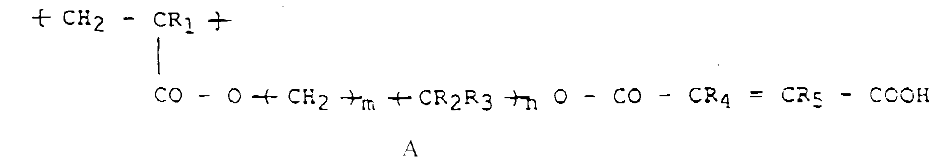 dans lequel R₁ peut représenter H et CH₃, R₂ et R₃ peuvent représenter indépendamment l'un de l'autre H et des groupes alkyle et aryle substitués ou non substitués et R₄ et R₅ peuvent représenter indépendamment l'un de l'autre H et des groupes alkyle substitués ou non substitués et m et n peuvent prendre une valeur de 0 à 10, la somme de m et n étant égale à 2 à 20.

10. Procédé de fabrication de formes d'impression flexographique, comprenant
1) l'exposition avec transfert d'image à l'aide d'un rayonnement actinique d'un cliché photopolymérisable selon une quelconque des revendications 1 à 7
a) à travers le film de recouvrement d) ou
b) après enlèvement du film de recouvrement d), à travers la couche élastomère c) ou
c) après enlèvement du film de recouvrement d), à travers un film de polymère souple e), dans la mesure où celui-ci se trouve dans le cliché photopolymérisable entre la couche d'élastomère c) et le film de recouvrement d), et
2) l'enlèvement du film polymère souple e), si présent, et des régions non exposées de la couche photopolymérisable b) et de la couche d'élastomère c) par lavage avec des solvant de développement.
